# EUROPEAN PATENT APPLICATION

(11) **EP 4 557 291 A1**
(43) Date of publication of application: **21.05.2025**
(21) Application number: 24209656.8
(22) Date of filing: 29.10.2024
(51) Int. Cl.: G11C 11/54, G11C 11/405, G06N 3/065

(54) **NEUROMORPHIC SEMICONDUCTOR DEVICE AND OPERATING METHOD THEREOF**

(30) Priority: 15.11.2023 KR 20230158331
(71) Applicant: POSTECH Research and Business Development Foundation, Pohang-si, Gyeongsangbuk-do 37673 (KR)
(72) Inventor: KIM, Seyoung, 37664 Gyeongsangbuk-do (KR); BYOUNGWOO, Lee, Gyeongsangbuk-do (KR)
(74) Representative: Germain Maureau

(57) **Abstract**

The present disclosure relates to a neuromorphic semiconductor device and an operation method thereof, and a resistive processing unit used as a synaptic element includes a first N-type metal oxide semiconductor (NMOS) transistor electrically connected to a first input terminal, a second NMOS transistor electrically connected to a second input terminal and connected in series with the first NMOS transistor, and a read transistor having its gate connected to the second NMOS transistor and configured to store charge and read the amount of stored charge.

## Description

### TECHNICAL FIELD

The present disclosure relates to a neuromorphic semiconductor device and an operation method thereof, and more specifically, to a neuromorphic semiconductor device using a resistive processing unit (RPU) including N-type metal oxide semiconductor (NMOS) elements and an operation method thereof.

### BACKGROUND

A deep neural network (Deep Neural Network, DNN) technology, which has been rapidly developed in recent years, has enabled the implementation of human cognitive abilities such as image and voice analysis, natural language processing, and autonomous systems that were previously difficult to implement with computers, and has led to a groundbreaking improvement in the performance of artificial intelligence.

Since the performance of deep neural networks tends to improve as the model size increases and the number of layers increases, larger and deeper neural networks are being developed to improve the performance of artificial intelligence. Currently, the enormous amount of calculation required for learning deep neural networks relies on parallel computing using a graphics processing unit (GPU).

However, computational acceleration using a GPU has a fundamental limitation of the memory bottleneck phenomenon that occurs in the von Neumann structure where the memory and computational devices are separated. Therefore, it is difficult to expect a dramatic improvement in the speed or energy efficiency of deep neural network learning through the improvement of traditional semiconductor integration, and a new paradigm computing method specialized in deep neural network operations is urgently required. Accordingly, the concept of a resistive processing unit (RPU) that can efficiently perform matrix multiplication operations, which account for the largest proportion of deep neural network operations, through analog operations has been proposed.

When this resistive processing unit is integrated in the form of a cross-point array, it can achieve a dramatically higher energy efficiency compared to existing digital systems. An ideal resistive processing unit element that can achieve such high neural network learning performance while dramatically accelerating the learning time must have more than 1,000 memory stages and satisfy the condition that the asymmetry of the update direction of the resistance state is within 5%, so the development of an ideal element that perfectly satisfies these requirements is currently being demanded.

Korean Patent No. 10-2020-0100286 relates to a neuromorphic circuit system capable of efficiently implementing negative weights, and the system includes a plurality of pre-neurons, a plurality of post-neurons, a plurality of synapses arranged at intersections of a plurality of row lines extending in a row direction from each of the pre-neurons and a plurality of column lines corresponding to each of the post-neurons to form a synapse array, a shift circuit weighting the inputs of the plurality of pre-neurons by shift weights, summing them, and outputting the summed result, and a subtraction circuit subtracting the output of the shift circuit from the output of each of the plurality of column lines and outputting the subtracted output to each of the post-neurons, in which each of the plurality of synapses has a weight shifted from the original weight to the shift weight.
[National Research and Development Projects Supporting Present Disclosure]
[Project Identification Number] 1711193975
[Project Number] 40025414
[Ministry Name] Ministry of Science and ICT
[Project Management (Specialized) Agency Name] National IT Industry Promotion Agency
[Research Project Name] Information and Communication Broadcasting Innovation Talent Training
[Research Project Name] Artificial Intelligence Graduate School Support (Pohang University of Science and Technology)
[Contribution Rate] 1/2
[Project Executing Agency Name] Pohang University of Science and Technology Industry-Academic Cooperation Foundation
[Research Period] January 1, 2023 to December 31, 2023
[National Research and Development Projects Supporting This Invention]
[Project Identification Number] 1711182797
[Project Number] 40025686
[Ministry Name Ministry of Science and ICT
[Project Management (Specialized) Agency Name] National Research Foundation of Korea]
[Research Project Name] Individual Basic Research (Ministry of Science and ICT) 33-2 2023-11-15
[Research Project Name] Development of Process-In-Memory Elements Based on Ultra-low Off-current Complementary MOSFET and Resistive Storage Type Read Element for High-Performance, Low-Power Artificial Intelligence Computation
[Contribution Rate] 1/2
[Project Performing Organization] Pohang University of Science and Technology
[Research Period] March 1, 2023 to February 29, 2024
[Prior Art Document]
[Patent Document]
Publication Patent No. 10-2020-0100286 (August 26, 2020)

### SUMMARY

An embodiment of the present disclosure provides a neuromorphic semiconductor device that enables symmetrical charging/discharging and a memory update by forming an analog array using a resistive processing unit including only a N-type metal oxide semiconductor (NMOS), and selective and parallel updates are possible even in a cross-point array by controlling a voltage pulse of a gate electrode of the NMOS, and an operation method thereof.

In addition, the present disclosure provides a neuromorphic semiconductor device and an operating method thereof capable of preventing discharge effects due to off-current current by reducing the off-current by applying a resistive processing unit in which the NMOSs are connected in series.

According to one embodiment of the present disclosure, there is provided a neuromorphic semiconductor device including a resistive processing unit used as a synaptic element and included in one cell, in which the resistive processing unit includes a first N-type metal oxide semiconductor (NMOS) transistor electrically connected to a first input terminal (V_{G1}) and having one end connected to a voltage source including a power supply voltage (V_{DD}) or a ground voltage (GND), and a second NMOS transistor electrically connected to a second input terminal (V_{G2}) and having one end connected to a gate of a read transistor, the first NMOS transistor and the second NMOS transistor being connected in series and the read transistor reading an amount of charge stored in the gate.

When charging the gate of the read transistor, the first NMOS transistor and the second NMOS transistor are set to an ON state (V_{G1} = V_{G2} > Vth), and then the voltage source is set to V_{DD}; when discharging the gate of the read transistor, the first NMOS transistor and the second NMOS transistor are set to the ON state, and then the voltage source is set to the ground (GND).

When the gate of the read transistor does not require charging, at least one of the first NMOS transistor or the second NMOS transistor is set to an OFF state (V_{G1} < Vth or V_{G2} < Vth), and in order to read the amount of charge stored in the gate of the read transistor, the first NMOS transistor and the second NMOS transistor are set to an OFF state (V_{G1} = V_{G2} < Vth).

According to another embodiment of the present disclosure, there is provided a neuromorphic semiconductor device comprising a resistive processing unit used as a synaptic element and included in one cell, in which the resistive processing unit includes a first N-type metal oxide semiconductor (NMOS) transistor electrically connected to a first input terminal (V_{G1}) and having one end connected to a voltage source including a power supply voltage (V_{DD}) or a ground voltage (GND), a second NMOS transistor electrically connected to a second input terminal (V_{G2}) and having one end connected to a capacitor, and a read transistor connected to the capacitor through a gate and configured to read an amount of charge charged in the capacitor, the first NMOS transistor and the second NMOS transistor being connected in series.

The first NMOS transistor and the second NMOS transistor include a thin film transistor (TFT), an organic semiconductor, hydrogenated amorphous silicon (a-Si:H), or a metal oxide semiconductor (MOS).

The voltage source connected to one end of the first NMOS transistor is electrically connected to a power supply voltage (V_{DD}) or a ground voltage (GND) through a switch.

Charging or discharging of the read transistor is controlled by selectively changing the power supply voltage (V_{DD}) or the ground voltage (GND).

The read transistor is configured to have the same NMOS form as the first NMOS transistor and the second NMOS transistor.

The resistive processing unit (RPU) is arranged in an array form to perform a selective update, and the gate electrodes of the first NMOS transistor are connected as a row line and the gate electrodes of the second NMOS transistor are connected as a column line to form an array.

When charging the resistive processing unit, the voltage source is set to V_{DD}, and the first NMOS transistor and the second NMOS transistor are controlled to an ON state (V_{G1} = V_{G2} > Vth), when discharging the resistive processing unit, the voltage source is set to GND, and the first NMOS transistor and the second NMOS transistor are controlled to an OFF state (V_{G1} = V_{G2} < Vth), and when not charging the resistive processing unit, at least one of the first NMOS transistor or the second NMOS transistor is controlled to an OFF state (V_{G1} < Vth or V_{G2} < Vth).

When reading the amount of charge charged in the capacitor, the first NMOS transistor and the second NMOS transistor are controlled to an OFF state (V_{G1} = V_{G2} < Vth) and the current is read through the read transistor.

The resistive processing unit further includes an accelerator having a voltage control function between the first NMOS transistor and the second NMOS transistor, and the accelerator controls a voltage drop between the first NMOS transistor and the second NMOS transistor or strengthens a voltage signal of the second NMOS transistor in order to increase the response speed of an element.

According to still another embodiment of the present disclosure, there is provided an operating method of a neuromorphic semiconductor device by an update operation using an array of resistive processing units including a first NMOS transistor and a second NMOS transistor connected in series and a read transistor connected to the second NMOS transistor through a gate, the operation method including: forming an array in which gate electrodes of the first NMOS transistor are connected as a row line and gate electrodes of the second NMOS transistor are connected as a column line; applying a first voltage to the row line connected to the gate electrode of the first NMOS transistor; applying a second voltage to the column line connected to the gate electrode of the second NMOS transistor; and selecting an operable resistive processing unit based on the first voltage and the second voltage applied to the row line and the column line, respectively, and updating the selected resistive processing unit.

When the first voltage and the second voltage applied to the row line and the column line are higher than a threshold voltage (Vth), an update operation of the corresponding resistive processing unit is performed, and when the first voltage and the second voltage applied to the row line and the column line are lower than the threshold voltage (Vth), the update operation of the corresponding resistive processing unit is not performed.

The operation method further includes reading an amount of charge charged in the gate through the read transistor in the resistive processing unit.

The resistive processing unit further includes a capacitor connected to one end of the second NMOS transistor, and the operation method further includes reading an amount of charge charged in the capacitor through the read transistor.

A V_{DD} voltage is applied to an input terminal to increase an amount of charge stored in the read transistor, and a GND voltage is applied to decrease the amount of stored charge.

The disclosed technology may have the following effects. However, it does not mean that a specific embodiment must include all or only the following effects, and therefore, the scope of the disclosed technology should not be understood as being limited thereby.

According to the neuromorphic semiconductor device and the operating method thereof according to one embodiment of the present disclosure, it is possible to perform symmetrical charging and discharging and memory updates by applying the resistive processing unit including only NMOS, and through this characteristic, when the neuromorphic semiconductor used as an accelerator for neural network acceleration, it is possible to obtain the effect of performing artificial intelligence learning and calculations quickly with low power.

In addition, by applying the resistive processing unit in which NMOSs are connected in series, it is possible to obtain the effect of preventing discharge due to off-current by reducing off-current.

### BRIEF DESCRIPTION OF THE DRAWINGS

FIGS. 1A to 2 illustrate a cell structure of a resistive processing unit (RPU) according to one embodiment of the present disclosure.
FIG. 3 illustrates a cross-section of a N-type metal oxide semiconductor (NMOS) transistor of FIG. 1.
FIG. 4 illustrates the resistive processing unit (RPU) cells of FIG. 2 arranged in an array form.
FIG. 5 illustrates a voltage pulse input to each transistor in the RPU cell of FIG. 1.
FIGS. 6 to 8 illustrate charge and discharge situations in the RPU structure according to one embodiment of the present disclosure.

### DETAILED DESCRIPTION

The description of the present disclosure is merely an embodiment for structural or functional explanation, so the scope of the rights of the present disclosure should not be interpreted as being limited by the embodiments described in the text. That is, since the embodiments can be modified in various ways and can have various forms, the scope of the rights of the present disclosure should be understood to include equivalents that can realize the technical idea. In addition, the purpose or effect presented in the present disclosure does not mean that a specific embodiment must include all of them or only include such effects, so the scope of the rights of the present disclosure should not be understood as being limited by them.

Meanwhile, the meanings of the terms described in this application should be understood as follows.

The terms "first", "second", and the like are intended to distinguish one component from another, and the scope of the right should not be limited by these terms. For example, a first component may be named a second component, and similarly, a second component may also be named a first component.

When a component is said to be "connected" to another component, it should be understood that it may be directly connected to the other component, but there may also be another component in between. Meanwhile, when a component is said to be "directly connected" to another component, it should be understood that there is no other component in between. Meanwhile, other expressions that describe the relationship between components, such as "between" and "immediately between" or "adjacent to" and "directly adjacent to", should be interpreted in the same way.

The singular expression should be understood to include the plural expression unless the context clearly indicates otherwise, and the terms such as "include" and "have" are intended to specify the presence of a feature, number, step, operation, component, part, or combination thereof implemented, and should be understood not to preclude the possibility of the presence or addition of one or more other features, numbers, steps, operations, components, parts, or combinations thereof.

The identification codes (e.g., a, b, c, or the like) for each step are used for convenience of explanation, and the identification codes do not describe the order of each step, and each step may occur in a different order than the stated order unless the context clearly indicates a specific order. In other words, each step may occur in the same order as the stated order, may be performed substantially simultaneously, or may be performed in the opposite order.

The present disclosure may be implemented as a computer-readable code on a computer-readable recording medium, and the computer-readable recording medium includes all kinds of recording devices on which data that can be read by a computer system is stored. Examples of computer-readable recording media include ROM, RAM, CD-ROM, magnetic tape, floppy disk, and optical data storage devices. In addition, the computer-readable recording media can be distributed across network-connected computer systems, so that computer-readable code can be stored and executed in a distributed manner.

All terms used herein, unless otherwise defined, have the same meaning as generally understood by a person of ordinary skill in the art to which the present disclosure belongs. Terms defined in commonly used dictionaries should be interpreted as having a meaning consistent with the context of the relevant technology, and cannot be interpreted as having an ideal or overly formal meaning unless explicitly defined in this application.

Hereinafter, with reference to the attached drawings, a preferred embodiment of the present disclosure will be described in more detail. The same reference numerals will be used for the same components in the drawings, and duplicate descriptions of the same components will be omitted.

Matrix operations using analog arrays are key operations for performing the learning and inference processes of artificial intelligence, and can improve computational performance by hundreds of times or more than existing digital hardware. A resistive processing unit, one of the types of cells that constitute the analog array, uses a transistor to control the charging/discharging of a capacitor and reads an amount of charge stored in the capacitor through a read transistor. Unlike the new memory elements that make up the existing analog array, the capacitor-based RPU is already technologically mature and has the advantage of linear and symmetrical weight updates. Therefore, when the capacitor-based RPU works well, a neuromorphic system that can exhibit high accuracy can be implemented.

In order to charge and discharge the capacitor, the capacitor should be connected to the capacitor in the source part of the P-type metal oxide semiconductor (PMOS) and NMOS (N-type metal oxide semiconductor), respectively. When charging, the NMOS is turned off and the PMOS is turned on, and the amount of charge in the capacitor is charged through a voltage applied to a drain of the PMOS, and conversely, when discharging, the PMOS is turned off and the NMOS is turned on, and the amount of charge in the capacitor is discharged through the ground connected to the drain of the NMOS. In order to preserve the amount of charge stored in the capacitor, off-current when the PMOS and NMOS are turned off should be very small. Since PMOS generally has a slower characteristic than NMOS, charging and discharging occur asymmetrically. Moreover, when an element with a large off current is used, the amount of charge stored in the capacitor cannot be accurately read.

The present disclosure proposes a structure that enables symmetrical charging and discharging using only NMOS and minimizes off-current. Two NMOSs are connected in series, and at one end, a voltage source (V_{DD}, gnd) is connected to the gate electrode of a read NMOS transistor that is charged and reads the amount of charge charged. The present disclosure proposes a structure that enables a symmetrical memory update and reduced off-current by using only NMOS when charging and discharging the transistor.

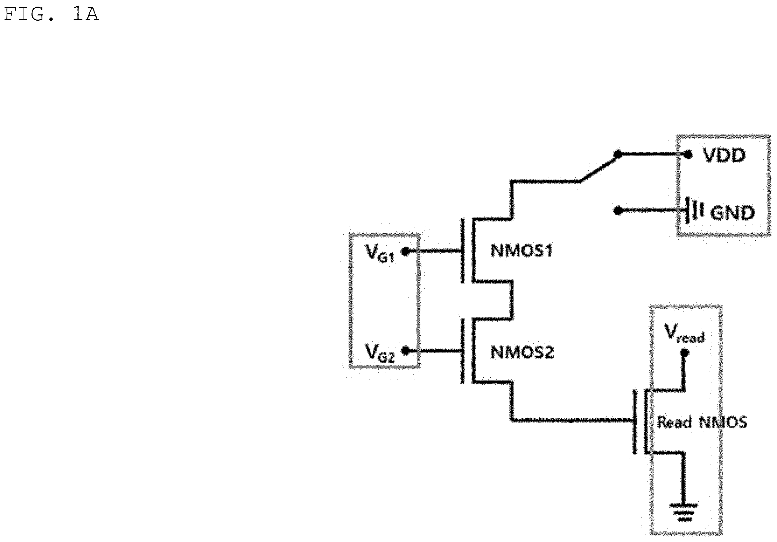

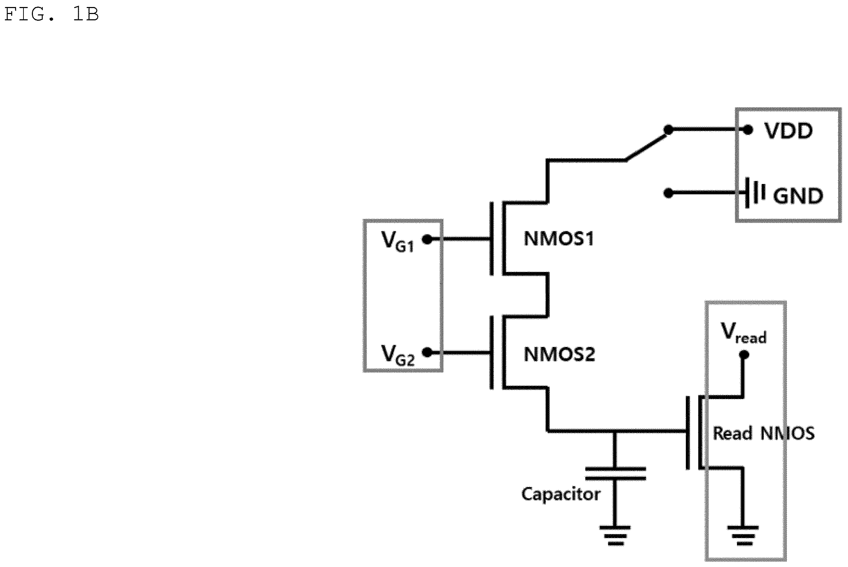

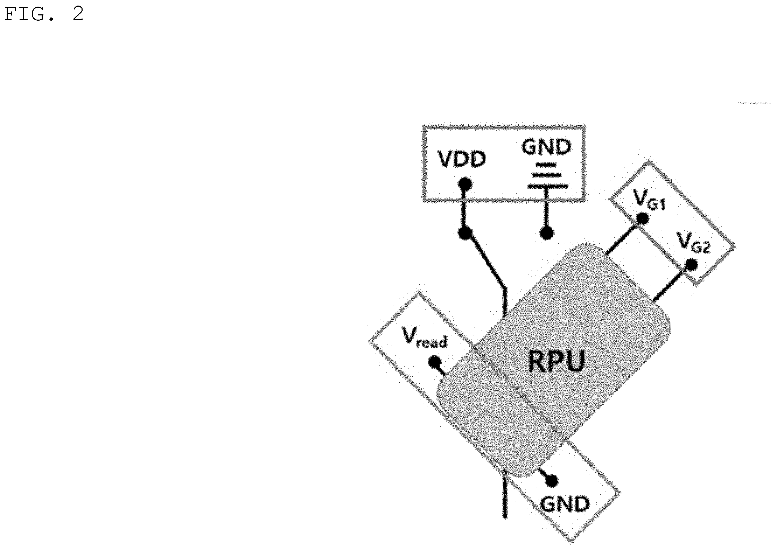

FIGS. 1A to FIG. 2 illustrate a cell structure of the resistive processing unit (RPU) according to an embodiment of the present disclosure. FIGS. 1A and 1B illustrate a circuit diagram of a cell of the RPU, and FIG. 2 illustrates a simplified diagram of a cell of an RPU.

Referring to FIG. 1A, FIG. 1B, and FIG. 2, a cell of a resistive processing unit (RPU) may be composed of a first transistor NMOS1 and a second transistor NMOS2 connected in series and a read transistor Read NMOS. In this case, it is preferable that the first transistor and the second transistor use NMOS elements, and the NMOS elements can be configured with TFT, organic semiconductor, hydrogenated amorphous silicon (a-Si:H), and metal oxide semiconductor (MOS).

First, in the resistive processing unit (RPU) cell of FIG. 1A, a gate electrode of the first transistor is electrically connected to an input terminal V_{G1}, and a gate electrode of the second transistor is electrically connected to an input terminal V_{G2}. The drain electrode of the first transistor can be electrically connected to a power supply voltage V_{DD} or a ground voltage GND through a switch.

In addition, the source electrode of the second transistor may be electrically connected to the gate electrode of the read transistor. In addition, the gate electrode of the read transistor Read NMOS is electrically connected to the source electrode of the second transistor, and the value of the amount of charge stored in the gate electrode of the read transistor may be read through an input terminal (V_{read}) connected to the drain electrode. The read transistor may use a nonvolatile memory element whose memory state changes by current or voltage, and use an electrochemical random access memory (ECRAM), a phase-change random access memory (PRAM), and a ferroelectric random access memory (FeRAM), for example.

In this case, when charging the gate electrode of the read transistor, two NMOSs of the first transistor and the second transistor are set to an ON state (V_{G1} = V_{G2} > Vth), and then the voltage source is set to V_{DD}. Conversely, when discharging, two NMOSs of the first transistor and the second transistor are set to the ON state, and then the voltage source is set to ground GND.

When charging is not required for the gate electrode of the read transistor, at least one of the two NMOSs is set to an OFF state (V_{G1} < Vth or V_{G2} < Vth). In order to read the amount of charge stored in the gate electrode of the read transistor, the two NMOSs are set to the OFF state (V_{G1} = V_{G2} < Vth), and the current may be read through the read transistor.

Meanwhile, in the resistive processing unit (RPU) cell of FIG. 1B, the gate electrode of the first transistor is electrically connected to the input terminal V_{G1}, and the gate electrode of the second transistor is electrically connected to the input terminal V_{G2}. The drain electrode of the first transistor can be electrically connected to the power supply voltage V_{DD} or the ground voltage GND through the switch.

Moreover, the second transistor is connected to the capacitor, and the capacitor is connected to the read transistor through the gate. The read transistor can read the amount of charge charged in the capacitor.

When charging the resistive processing unit, the voltage source is set to V_{DD}, and the first NMOS transistor and the second NMOS transistor are controlled to be in the ON state (V_{G1} = V_{G2} > Vth). Conversely, when discharging the resistive processing unit, the voltage source is set to GND, and the first NMOS transistor and the second NMOS transistor are controlled to be in the OFF state (V_{G1} = V_{G2} < Vth).

In addition, when not charging the resistive processing unit, at least one of the first NMOS transistor and the second NMOS transistor is controlled to be in the OFF state (V_{G1} < Vth or V_{G2} < Vth).

In addition, when reading the amount of charge charged in the capacitor, the first NMOS transistor and the second NMOS transistor are controlled to be in the OFF state (V_{G1} = V_{G2} < Vth), and the current can be read through the read transistor.

The resistive processing unit further includes an accelerator having a voltage control function between the first NMOS transistor and the second NMOS transistor, and the accelerator controls a voltage drop between the first NMOS transistor and the second NMOS transistor or strengthens a voltage signal of the second NMOS transistor in order to increase the response speed of the element.

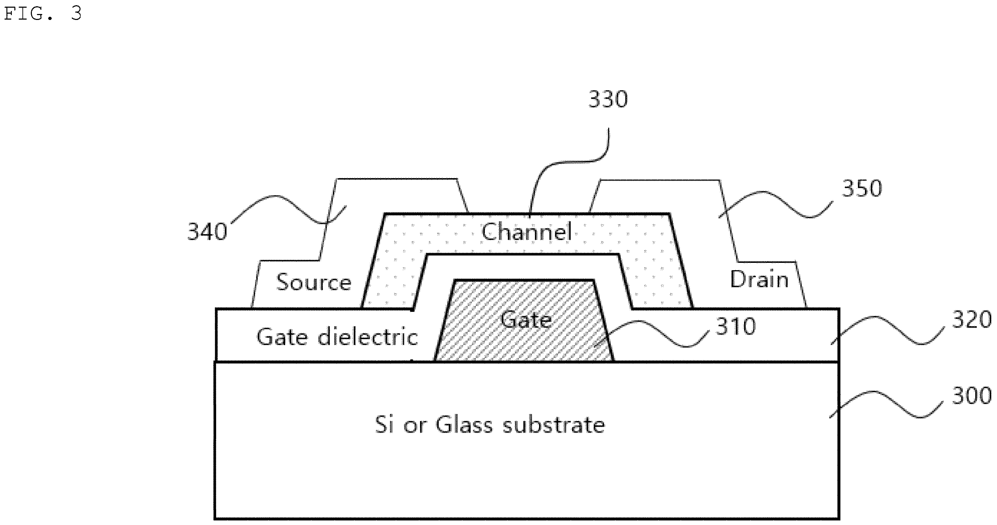

FIG. 3 is a drawing illustrating a cross-section of the NMOS transistor of FIG. 1, and illustrates a cross-section in the case where the first transistor or the second transistor of the resistive processing unit (RPU) cell is configured as a thin film transistor (TFT).

Referring to FIG. 3, a transistor configured as the TFT device is provided with a gate electrode 310 on an upper portion of a semiconductor substrate 300, and a gate dielectric layer 320 is provided on the entire surface of the semiconductor substrate 300 including the gate electrode 310. The gate dielectric layer 320 may include any one selected from a combination of SiO₂, HfO₂, Al2O₃, TiO₂, ZrO₂, SiNx, Si3N₄, Ta₂O₅, and SrTiO₃. A channel region 330 is provided on the upper portion of the gate dielectric layer 320, and a source electrode 340 and a drain electrode 350 are provided in each of both sides of the channel region 330. The TFT element of this structure is an Ohmic Contact type in which current flows in an accumulation stage, and no voltage is applied to the semiconductor substrate.

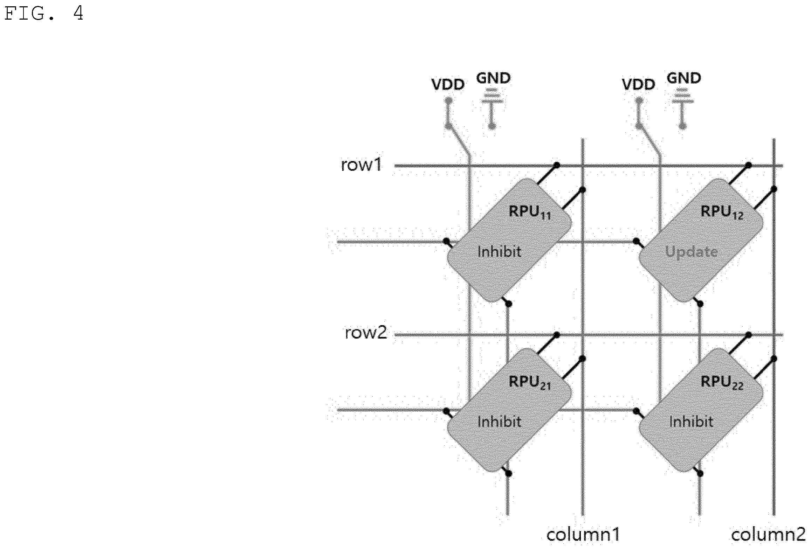

FIG. 4 illustrates the resistive processing unit (RPU) cells of FIG. 2 arranged in an array form.

A synapse array composed of a plurality of resistive processing unit (RPU) cells represents an n x m synapse array using synaptic elements in an analog hardware accelerator, and includes a plurality of row lines extending in a first direction and a plurality of column lines extending in a second direction perpendicular to the first direction. The n x m synapse array has nm synapses connecting n neurons of the i-th layer and m neurons of the i+1-th layer as elements, and can be expressed as RPUₙₘ here.

Referring to FIG. 4, a method of making RPU cells into a 2 X 2 array and selectively performing an update is described as follows.

First, the gate electrodes of the first transistor of the resistive processing unit (RPU) cell are connected to the row line, and the gate electrodes of the second transistor are connected to the column line to form an array.

A neural network device including such an array is described as one of the selective update methods, in which a voltage higher than Vth is applied to the first row line row1 and the second column line column2, and a voltage lower than Vth is applied to the second row line row2 and the first column line column1. When voltages are applied in this way, only RPU12, to which a voltage higher than Vth is applied to the row line and the column line, is updated, and the remaining elements are not updated.

In addition, when increasing the amount of charge stored in the gate electrode of the read transistor in the RPU cell, a voltage of V_{DD} may be applied to the drain line, and conversely, when decreasing the amount of charge stored in the gate electrode, a voltage of GND may be applied to the drain line.

This allows for selective updating of elements in the array. In addition, when reading data stored in the element, by applying an appropriate voltage to the row line of the read line and reading the current coming out of the column line, data stored in the element can be selectively read.

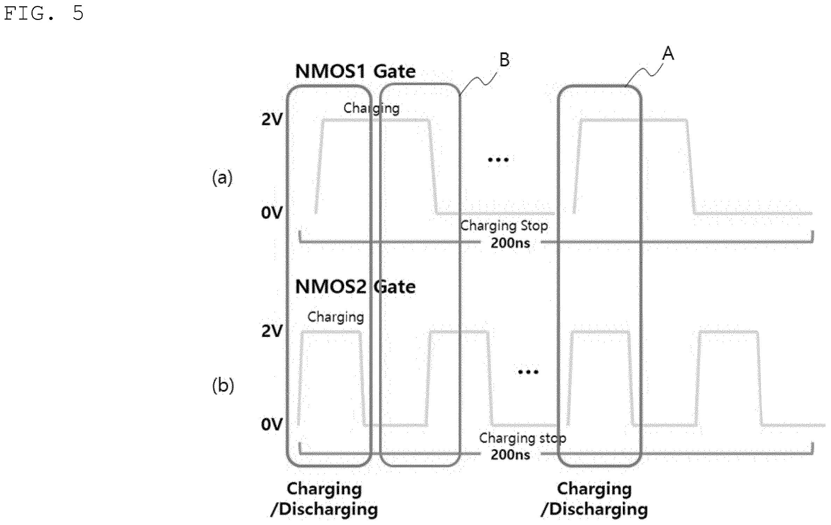

FIG. 5 illustrates voltage pulses input to each transistor in the RPU cell of FIG. 1.

FIG. 5(a) illustrates a voltage pulse applied to the gate electrode of the first transistor NMOS1, and FIG. 5(b) illustrates a voltage pulse applied to the gate electrode of the second transistor NMOS2. In this case, charging or discharging occurs only when the voltages applied to the gate electrodes of the first and second transistors are high at the same time, as in "A". Meanwhile, when the voltage applied to only one of the gate electrodes of the first transistor (NMOS1) or the second transistor (NMOS2) is high, as in "B", charging or discharging does not occur.

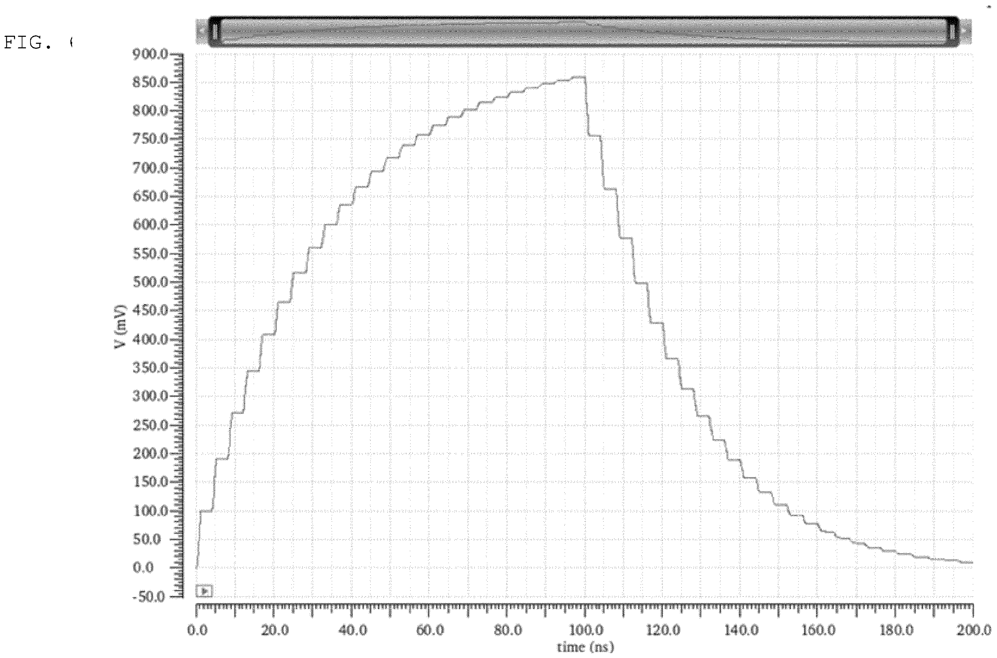

FIG. 6 to 8 are graphs illustrating the charging and discharging situation in the RPU structure according to one embodiment of the present disclosure.

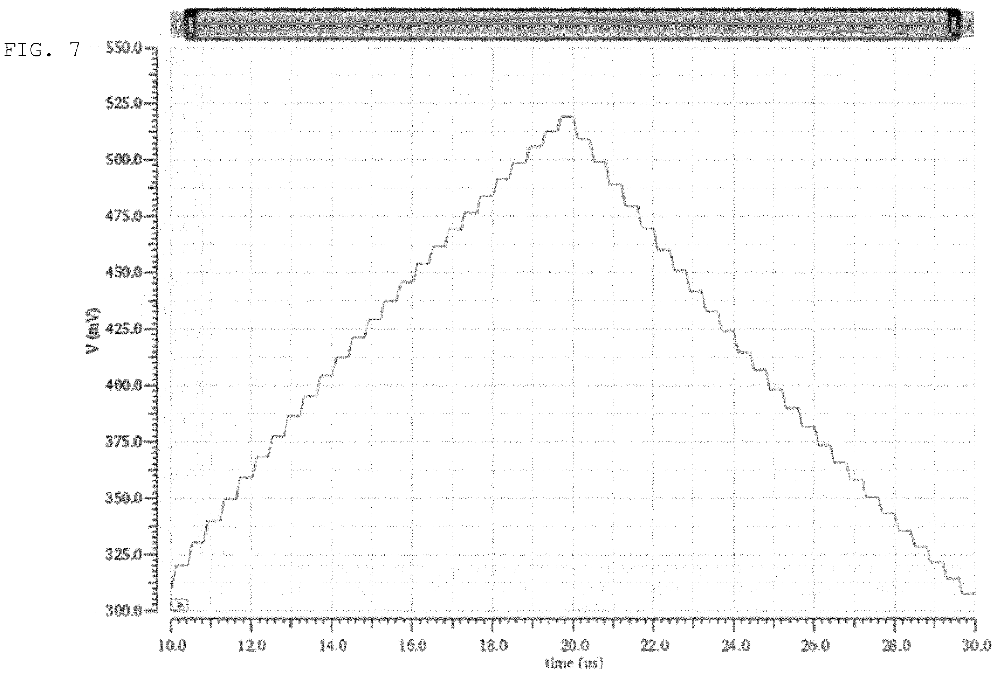

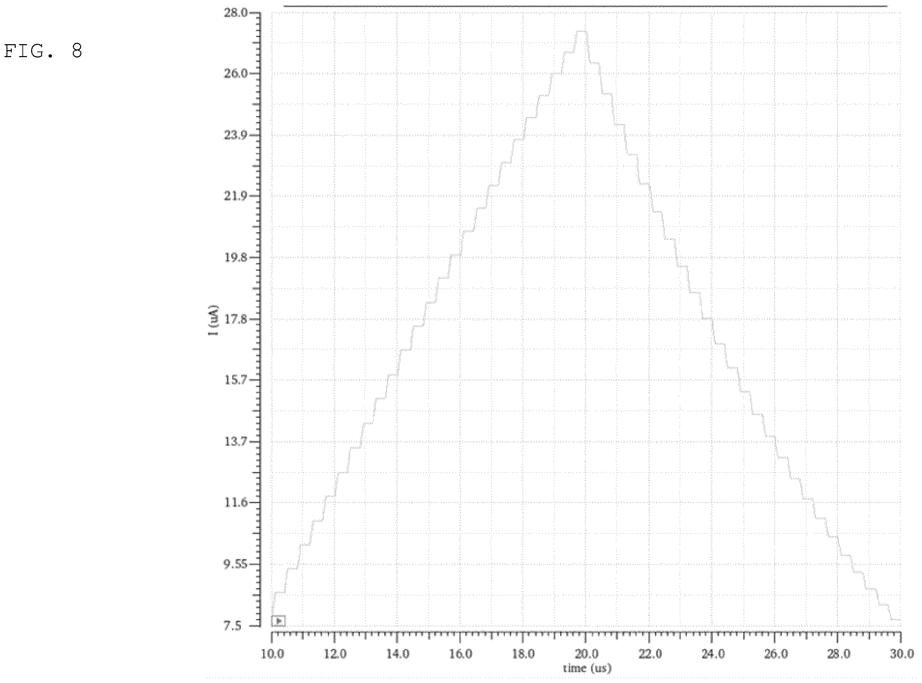

FIG. 6 is a graph illustrating that charging and discharging occur continuously by applying a continuous voltage pulse to the gate electrode of the RPU cell. FIG. 7 is a graph illustrating that linear and symmetrical charging and discharging patterns appear when the voltage pulse is limited to a specific voltage range. In addition, FIG. 8 is a graph illustrating that the current is read linearly and symmetrically when the amount of charge stored in the gate electrode of the read transistor is read by the read transistor.

As described above, symmetrical and linear analog updates are possible by using a resistive processing unit in which two NMOS devices are connected in series, and selective and parallel updates can be made possible even in a cross-point array by controlling the voltage pulse applied to the gate electrodes of the two NMOS devices. When the RPU element with these advantages is utilized as an analog memory element and arrayed and used as an accelerator for a neuromorphic system, artificial intelligence learning and calculation can be performed quickly with low power compared to existing digital systems.

Although the present disclosure has been described above with reference to preferred embodiments thereof, it will be understood by those skilled in the art that the present disclosure may be variously modified and changed without departing from the spirit and scope of the present disclosure set forth in the claims below.

**[Detailed Description of Main Elements]**

| | | | |
|---|---|---|---|
| NMOS1: | first transistor | NMOS2: | second transistor |
| 300: | semiconductor substrate | 310: | gate electrode |
| 320: | gate dielectric layer | 330: | channel region |
| 340: | source electrode | 350: | drain electrode |

## Claims

1. A neuromorphic semiconductor device comprising a resistive processing unit used as a synaptic element and included in one cell,
wherein the resistive processing unit includes
a first N-type metal oxide semiconductor (NMOS) transistor electrically connected to a first input terminal (V_{G1}) and having one end connected to a voltage source including a power supply voltage (V_{DD}) or a ground voltage (GND), and
a second NMOS transistor electrically connected to a second input terminal (V_{G2}) and having one end connected to a gate of a read transistor,
the first NMOS transistor and the second NMOS transistor being connected in series and the read transistor reading an amount of charge stored in the gate.

2. The neuromorphic semiconductor device of claim 1, wherein when charging the gate of the read transistor, the first NMOS transistor and the second NMOS transistor are set to an ON state (V_{G1} = V_{G2} > Vth), and then the voltage source is set to V_{DD}, and
when discharging the gate of the read transistor, the first NMOS transistor and the second NMOS transistor are set to the ON state, and then the voltage source is set to the ground (GND).

3. The neuromorphic semiconductor device of claim 1, wherein when the gate of the read transistor does not require charging,
at least one of the first NMOS transistor or the second NMOS transistor is set to an OFF state (V_{G1} < Vth or V_{G2} < Vth), and
in order to read the amount of charge stored in the gate of the read transistor, the first NMOS transistor and the second NMOS transistor are set to an OFF state (V_{G1} = V_{G2} < Vth).

4. A neuromorphic semiconductor device comprising a resistive processing unit used as a synaptic element and included in one cell,
wherein the resistive processing unit includes
a first N-type metal oxide semiconductor (NMOS) transistor electrically connected to a first input terminal (V_{G1}) and having one end connected to a voltage source including a power supply voltage (V_{DD}) or a ground voltage (GND),
a second NMOS transistor electrically connected to a second input terminal (V_{G2}) and having one end connected to a capacitor, and
a read transistor connected to the capacitor through a gate and configured to read an amount of charge charged in the capacitor,
the first NMOS transistor and the second NMOS transistor being connected in series.

5. The neuromorphic semiconductor device of claim 4, wherein the first NMOS transistor and the second NMOS transistor include a thin film transistor (TFT), an organic semiconductor, hydrogenated amorphous silicon (a-Si:H), or a metal oxide semiconductor (MOS).

6. The neuromorphic semiconductor device of claim 4, wherein the voltage source connected to one end of the first NMOS transistor is electrically connected to a power supply voltage (V_{DD}) or a ground voltage (GND) through a switch.

7. The neuromorphic semiconductor device of claim 4, wherein charging or discharging of the read transistor is controlled by selectively changing the power supply voltage (V_{DD}) or the ground voltage (GND).

8. The neuromorphic semiconductor device of claim 4, wherein the read transistor is configured to have the same NMOS form as the first NMOS transistor and the second NMOS transistor.

9. The neuromorphic semiconductor device of claim 4, wherein the resistive processing unit (RPU) is arranged in an array form to perform selective update, and the gate electrodes of the first NMOS transistor are connected as a row line and the gate electrodes of the second NMOS transistor are connected as a column line to form an array.

10. The neuromorphic semiconductor device of claim 4, wherein when charging the resistive processing unit, the voltage source is set to V_{DD}, and the first NMOS transistor and the second NMOS transistor are controlled to be in an ON state (V_{G1} = V_{G2} > Vth),
when discharging the resistive processing unit, the voltage source is set to GND, and the first NMOS transistor and the second NMOS transistor are controlled to be in an OFF state (V_{G1} = V_{G2} < Vth), and
when not charging the resistive processing unit, at least one of the first NMOS transistor or the second NMOS transistor is controlled to be in an OFF state (V_{G1} < Vth or V_{G2} < Vth).

11. The neuromorphic semiconductor device of claim 4, wherein when reading the amount of charge charged in the capacitor, the first NMOS transistor and the second NMOS transistor are controlled to be in an OFF state (V_{G1} = V_{G2} < Vth) and the current is read through the read transistor.

12. The neuromorphic semiconductor device of claim 1, wherein the resistive processing unit further includes an accelerator having a voltage control function between the first NMOS transistor and the second NMOS transistor, and the accelerator controls voltage drop between the first NMOS transistor and the second NMOS transistor or strengthens a voltage signal of the second NMOS transistor in order to increase the response speed of an element.

13. An operating method of a neuromorphic semiconductor device by an update operation using an array of resistive processing units including a first NMOS transistor and a second NMOS transistor connected in series and a read transistor connected to the second NMOS transistor through a gate, the operation method comprising:
forming an array in which gate electrodes of the first NMOS transistor are connected as a row line and gate electrodes of the second NMOS transistor are connected as a column line;
applying a first voltage to the row line connected to the gate electrode of the first NMOS transistor;
applying a second voltage to the column line connected to the gate electrode of the second NMOS transistor; and
selecting an operable resistive processing unit based on the first voltage and the second voltage applied to the row line and the column line, respectively, and updating the selected resistive processing unit.

14. The operation method of claim 13, wherein when the first voltage and the second voltage applied to the row line and the column line are higher than a threshold voltage (Vth), an update operation of the corresponding resistive processing unit is performed, and
when the first voltage and the second voltage applied to the row line and the column line are lower than the threshold voltage (Vth), the update operation of the corresponding resistive processing unit is not performed.

15. The operation method of claim 13, further comprising reading an amount of charge charged in the gate through the read transistor in the resistive processing unit.

16. The operation method of claim 13, wherein the resistive processing unit further includes a capacitor connected to one end of the second NMOS transistor, and the operation method further includes reading an amount of charge charged in the capacitor through the read transistor.

17. The operation method of claim 13, wherein a V_{DD} voltage is applied to an input terminal to increase an amount of charge stored in the read transistor, and a GND voltage is applied to decrease the amount of stored charge.
